# EUROPEAN PATENT SPECIFICATION

(11) **EP 4 203 207 B1**
(45) Date of publication and mention of the grant of the patent: **05.06.2024**
(21) Application number: 21306920.6
(22) Date of filing: 23.12.2021
(51) Int. Cl.: H01S 5/028, H01S 5/062, H01S 5/12, H01S 5/125, H01S 5/22

(54) **DISTRIBUTED FEEDBACK LASERS AND METHODS FOR FABRICATING SUCH LASERS**
LASER MIT VERTEILTER RÜCKKOPPLUNG UND VERFAHREN ZUR HERSTELLUNG SOLCHER LASER
LASERS À RÉTROACTION RÉPARTIE ET PROCÉDÉS DE FABRICATION DE TELS LASERS

(43) Date of publication of application: 28.06.2023
(73) Proprietor: Almae Technologies, 91460 Marcoussis (FR)
(72) Inventor: Debrégeas, Hélène, 91470 Boullay-les-Troux (FR); Carrara, David, 91600 Savigny sur Orge (FR); Dubrovina, Natalia, 91300 Massy (FR); Belahsene, Sofiane, 93110 Rosny sous bois (FR)
(74) Representative: Osha BWB

(56) References cited:
- WO-A1-2021/168851
- US-A1- 2012 051 386
- US-A1- 2019 165 544
- JONG-IN SHIM ET AL: "LASING CHARACTERISTICS OF 1.5 UM GAINASP-INP SCH-BIG-DR LASERS", IEEE JOURNAL OF QUANTUM ELECTRONICS, IEEE, USA, vol. 27, no. 6, 1 June 1991 (1991-06-01), pages 1736-1745, XP000229990, ISSN: 0018-9197, DOI: 10.1109/3.89999

## Description

### TECHNICAL FIELD OF THE INVENTION

The present description relates to distributed feedback lasers. Further, the present description relates to methods for fabricating such lasers.

### BACKGROUND OF THE INVENTION

Semiconductor devices configured to emit light are used in many technical fields such as optical sensing and optical communications. Distributed feedback (DFB) lasers are a particular type of semiconductor devices with a laser section comprising an active layer configured to emit light, for example an ensemble of quantum wells, or multi-quantum-wells (MQW), and a Bragg grating configured to select a central wavelength of the emitted light. The Bragg grating is arranged in a planar layer that is parallel to said active layer. Further, in such devices, the laser section is arranged between a front facet and a rear facet, the light being emitted out of the device through the front facet.

For most applications, a single-mode operation of the laser is generally preferred, i.e. when the emitted light has a bandwidth predominantly centered at a single wavelength. However, in a classical DFB laser, the presence of the Bragg grating in the laser section generally favors emission of light at two different wavelengths (dual-mode operation) separated by a spectral range referred to as the stopband of the laser.

The stop-band depends on the product of the length (L) of the laser section and the coupling coefficient (κ) of the laser section, also referred to as coupling strength, defined as the "reflectivity per unit length" of the DFB laser and expressed in cm⁻¹.

In order to avoid dual-mode operation, an asymmetry is generally introduced in the DFB laser by adding, on the one hand, a mirror section consisting of a highly reflective (HR) coating at the rear facet and, on the other hand, an anti-reflection (AR) coating at the front facet. With said arrangement, referred to as HR/AR DFB lasers, one of the two modes in operation is favored over the other mode. Further, the optical power of the light emitted at the front facet is substantially doubled compared to a DFB laser without coatings, as almost no light is emitted through the rear facet.

However, it is generally not possible to control the exact position of the rear facet with respect to the Bragg grating, mainly due to fabrication constraints. As a result, upon back-and-forth propagation in the laser section and reflection on the HR coating, light generated in the active layer acquires a phase shift that cannot be predicted, which is also referred to as a "random phase condition". Such random phase condition leads to variable performances between distinct DFB lasers, such as variations of the output power and variations of the wavelength of the emitted light within the stop-band. In particular, the wavelength of the emitted light may not be controlled better than within the stopband and the single-mode yield, or probability of the DFB laser to emit light in a single-mode, is reduced to typically 80-90% which imposes DFB laser testing and selection for applications such as wavelength division multiplexing (WDM) wherein specific transmission channels are used.

To address such limitations, it is known to make DFB lasers wherein an asymmetry is introduced by a laser section comprising a phase shift equal to a fourth of the period of the Bragg grating in the middle of the Bragg grating and anti-reflection coatings on both the rear facet and the front facet, see for example [REF 1]. Such a DFB laser, referred to as quarter-wave (λ/4) phase shift DFB laser, emits light with a central wavelength that is naturally in the center of the stop-band. Therefore, such solution provides 100% single-mode yield and accurate control of the emitted wavelength. However, λ/4 phase shift DFB lasers are emitting light both at the rear facet and the front facet, causing a 50% reduction of emitted power from one facet compared to HR/AR DFB lasers.

Alternatively, in [REF2], a DFB laser is proposed wherein a mirror section is arranged on a side of the laser section, wherein such mirror section comprises a distributed Bragg reflector (DBR) with a second Bragg grating. Said second Bragg grating is arranged in a planar layer that is parallel to the active layer and coplanar with the planar layer of the first Bragg grating of the laser section.

In such arrangement, during the fabrication of the DFB laser, it is possible to etch the first Bragg grating in the laser section and the second Bragg grating in the mirror section with the same etching mask. Therefore, the spacing between the first grating and the second grating is precisely defined by said etching mask. Thus, it is possible to accurately control the phase shift acquired by light upon propagation from the first Bragg grating in the laser section to the second Bragg grating in the mirror section and hereby achieve both a high single-mode yield and an accurate control of the wavelength of the emitted light.

However, in the arrangement of [REF 2], the reflectivity of the mirror section depends on the product of the coupling strength of the mirror section and the length of the mirror section. In particular, as the coupling strength of the mirror section appears to be low (approximately equal to 200 cm⁻¹), a long mirror section is required to obtain a satisfying reflectivity of the mirror section, in particular a length between 300 micrometers and 480 micrometers. Further, such low coupling strength causes narrow reflectivity spectrum of the mirror section which imposes stringent constraints on the difference between the refractive index of the laser section and the refractive index of the mirror section. In particular, such low coupling strength imposes a laser section and a mirror section with very specific vertical structures comprising a single quantum well which are not compatible with many applications.

US 2019/165544 A1 discloses a method for fabricating a DFB laser comprising a first Bragg grating in the grating layer of the first section and a second Bragg grating in a planar layer of a second section that is coplanar with the active layer.

There is thus a need for alternative distributed feedback lasers having mirror sections with higher coupling strengths than in the prior art while keeping short mirror sections.

### SUMMARY

In what follows, the term "comprise" is synonym of (means the same as) "include" and "contains", is inclusive and open, and does not exclude other non-recited elements. Moreover, in the present disclosure, when referring to a numerical value, the terms "about" and "substantially" are synonyms of (mean the same as) a range comprised between 80% and 120%, preferably between 90% and 110%, of the numerical value.

According to a first aspect, the present disclosure relates to a method for fabricating a distributed feedback laser, comprising:
- providing a planar substrate, an active layer substantially parallel to the planar substrate but not coplanar with said planar substrate, and a grating layer arranged in a planar layer substantially parallel to said active layer but not coplanar with said active layer and arranged on a side of said active layer opposite to the planar substrate;
- covering with a mask a first section of an ensemble made of said planar substrate, said active layer and said grating layer, wherein said first section is intended to produce a laser section;
- removing at least the grating layer in a second section of said ensemble made of said planar substrate, said active layer and said grating layer, wherein said second section is intended to produce a mirror section;
- providing, in a single step, a grating mask covering at least partially the first section and at least partially the second section, such grating mask being configured to define a first Bragg grating in the first section and a second Bragg grating in the second section;
- producing, using said grating mask, the first Bragg grating in the grating layer of the first section and the second Bragg grating in a planar layer of the second section that is coplanar with the active layer.

According to one or further embodiments, the first Bragg grating and the second Bragg grating are produced, using said grating mask, in a single step.

With a method according to the third aspect, it is possible to produce a DFB laser with a mirror section having a higher coupling strength than in the prior art while keeping a simple process; therefore, constraints on the type and structure of the layers used in the laser section and mirror section are released. In particular, such method is compatible with different structures of distributed feedback lasers, directly modulated lasers and externally modulated lasers.

Further, with a method according to the third aspect, the first Bragg grating and the second Bragg grating can be defined in a single step using a single grating mask. Therefore, it is possible to precisely control the spacing between the first Bragg grating and the second Bragg grating in order to choose a phase shift acquired by light upon propagation between said first Bragg grating and said second Bragg grating.

Further, the phase shift can be controlled in order to control the photons distribution along the laser section and mirror section and homogenize power distribution by reducing photon concentration in the mirror section. In particular, this allows for a precise control of the wavelength of the emitted light, a reduction of spatial hole burning effect and an increase in the power emitted at the front facet which is beneficial for low linewidth and/or high-power lasers.

According to one or further embodiments, the second Bragg grating is produced in at least a part of said active layer that extends in the mirror section.

Such embodiments provide a simple design for the DFB laser, wherein the active layer is used both in the laser section to emit light and in the mirror section to form regions of the second Bragg grating.

According to one or further embodiments, the second Bragg grating is produced through only a part of the thickness of said active layer but not throughout all the thickness of said active layer.

According to one or further embodiments, said part of the active layer has a thickness between about 50 nanometers and about 200 nanometers, preferably between about 50 nanometers and about 120 nanometers.

According to one or further embodiments, the second Bragg grating is produced in at least a part of an auxiliary waveguide that is coupled to the active layer of the first section.

According to one or further embodiments, the active layer and said auxiliary waveguide are coupled through butt-coupling, evanescent coupling, selective area growth or intermixing.

According to one or further embodiments, the second Bragg grating is produced through only a part of the thickness of said auxiliary waveguide layer but not throughout all the thickness of said auxiliary waveguide layer.

A distributed feedback (DFB) laser obtained using the method according to the first aspect comprises:
- a planar substrate;
- a laser section comprising a front facet, an active layer substantially parallel to the planar substrate but not coplanar with said planar substrate and configured to emit light through said front facet, and a first Bragg grating arranged in a planar layer substantially parallel to the active layer but not coplanar with said active layer and on a side of the active layer opposite to the planar substrate;
- a mirror section optically coupled to said laser section, comprising a second Bragg grating configured to reflect light towards said front facet;
wherein said second Bragg grating is arranged in a planar layer that is coplanar with said active layer.

In the present description, two planar layers that are coplanar means that an upper surface of the first of the two planar layers is at a predetermined distance from an upper surface of the second of the two planar layers that is inferior to a maximum distance, wherein said maximum distance is equal or inferior to about 50 nanometers, for example equal or inferior to about 20 nanometers.

Conversely, two planar layers are not coplanar when said predetermined distance is superior to said maximum distance.

With such configuration, an overlap between guided optical light in the active layer and said second Bragg grating is improved compared to arrangements of the prior art, so that the mirror section has a higher coupling strength than mirror sections disclosed in the prior art. Therefore, it is possible to obtain a satisfying reflectivity with a mirror section that is shorter than in the prior art. Subsequently, the length of the DFB laser is also reduced compared to the prior art, which is beneficial for footprint and cost reduction.

Further, by virtue of the high coupling strength in the mirror section, such a configuration is particularly adapted to DFB lasers having a high confinement of optical modes in the active layer. In particular, such a configuration is advantageously adapted to DFB lasers configured to form high-speed directly modulated lasers (DML) and to DFB lasers that are part of photonic integrated circuits configured to form high speed externally modulated lasers (EML).

Further, by virtue of the high coupling strength of the mirror section, the reflectivity spectrum of the mirror section is wider than in the prior art, which overcomes constraints of the prior art regarding the difference between the refractive index of the laser section and the refractive index of the mirror section. Therefore, such an arrangement is compatible with a large variety of DFB laser structures, in particular in terms of the materials used in the laser section and in the mirror section.

Such a compatibility is particularly advantageous in the case of a DFB laser wherein the mirror section comprises a stack of layers with a structure that is generally used for other purposes than a mirror section, for example a structure used in a modulation section of an externally modulated laser, or a passive waveguide, a coupler, a filter, or a multiplexer.

Further, with such configuration, a spacing between the first Bragg grating of the laser section and the second Bragg grating of the mirror section is deterministic and light propagating from the first Bragg grating to the second Bragg grating acquires a predetermined phase shift. Therefore, it is possible to obtain a DFB laser with deterministic performances.

In particular, it is possible to choose a spacing between the first Bragg grating of the laser section and the second Bragg grating of the mirror section so that light acquires a phase shift suitable for increasing the power of the light emitted at the front facet, which is beneficial for low-linewidth and/or high-power lasers.

According to one or further embodiments, a spacing between the first Bragg grating of the laser section and the second Bragg grating of the mirror section is introduced so that light propagating from the first Bragg grating to the second Bragg gating acquires a phase shift equal to about π/2, i.e., when light is propagating in transmission from one section to the other section. Consequently, when evaluated in reflection, i.e. when propagating back and forth between the two sections, said phase shift is equal to approximately π.

With such a phase shift, it is possible that the emitted light has a wavelength spectrum and a stopband wherein said wavelength spectrum is centered within the stopband.

According to one or further embodiments, said active layer extends to said mirror section, and said second Bragg grating is etched through at least a part of said active layer in the mirror section.

Such a configuration provides a simple design for the DFB laser, wherein the same active layer is used both in the laser section to emit light and in the mirror section to form regions of the second Bragg grating.

According to one or further embodiments, said mirror section comprises an auxiliary waveguide comprising transparent material, wherein said auxiliary waveguide is optically coupled to said active layer; and said second Bragg grating is etched through at least a part of said auxiliary waveguide.

In the present description, a transparent material is a material with an energy bandgap superior to an energy corresponding to the wavelength of light configured to be emitted by the active layer of the DFB laser.

In such a configuration, the auxiliary waveguide is coupled to the laser section using, for example, butt-coupling technology, evanescent coupling, selective area growth or intermixing. Therefore, is it possible to use a large variety of auxiliary waveguide structures in the mirror section, including structures generally used for other purposes than in a mirror section, for example structures used in modulation sections, in couplers, or in multiplexers.

According to one or further embodiments, said auxiliary waveguide is a passive waveguide, wherein a passive waveguide is a waveguide that does not comprise an active material configured to produce light.

Such a configuration provides a mirror section that is passive and therefore that does not require any current or voltage power. Therefore, such configuration has a lower power consumption than a configuration comprising an active mirror section.

According to one or further embodiments, the mirror section has a length along the direction of light propagation that is inferior to about 200 micrometers.

According to one or further embodiments, the DFB laser is configured to be a directly modulated laser.

According to a second aspect, the present disclosure relates to a photonic integrated circuit comprising a at least a first DFB laser obtained using a method according to the first aspect; and at least a first auxiliary section configured to receive light emitted by the DFB laser. Examples of such auxiliary section comprise a phase or an amplitude modulator, in which case the photonic integrated circuit is an externally modulated laser.

By virtue of the high coupling strength of the mirror section, such a DFB laser can be integrated with various auxiliary sections comprising a large variety of structures.

According to one or further embodiments, said at least first auxiliary section is a modulation section configured to modulate the phase and/or the amplitude of the light emitted by said at least first DFB laser.

According to one or further embodiments, said at least first auxiliary section is a transparent section configured to guide the light emitted by said at least first DFB laser, for example a coupler, a multiplexer, a demultiplexer or a filter.

According to a third aspect, the present disclosure relates to an integrated laser array comprising at least two DFB lasers obtained using a method according to the first aspect. According to one or further embodiments, said at least two DFB lasers are configured to emit light at at least two different wavelengths.

Such a configuration allows for controlling the wavelength of the emitted light while providing a higher output power and a smaller size than integrated laser arrays of the prior art.

### BRIEF DESCRIPTION OF DRAWINGS

Other advantages and features of the invention will become apparent on reading the description, illustrated by the following figures which represent:
- FIG. 1 represents a section view of a DFB laser along the direction of light propagation, according to embodiments;
- FIGS. 2A-2C represent steps of a method for fabricating a DFB laser according to an embodiment;
- FIGS. 3A-3C represent steps of a method for fabricating a DFB laser according to another embodiment.

### DETAILED DESCRIPTION

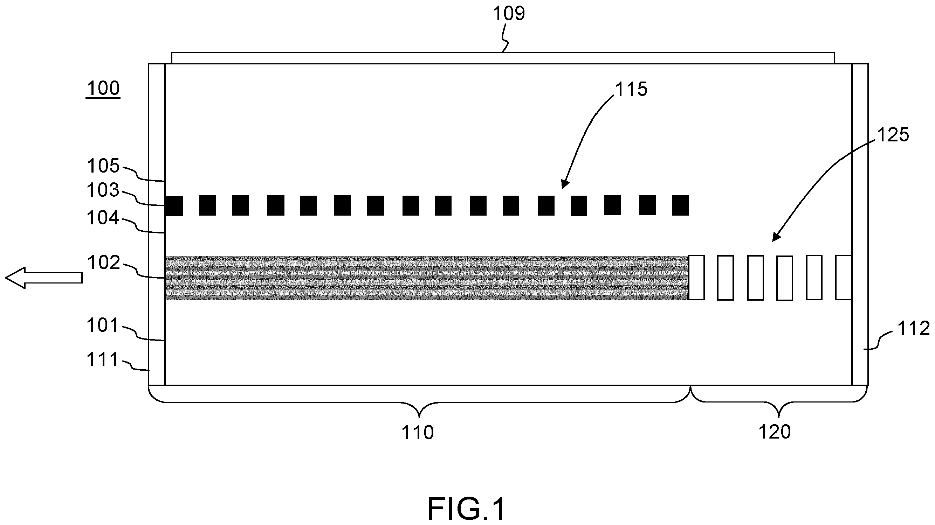

FIG. 1 represents a sectional view of an example of a DFB laser 100 according to the present disclosure along the direction of propagation of light in the DFB laser 100. The DFB laser 100 comprises a laser section 110 configured to emit light and a mirror section 120 configured to reflect light emitted by the laser section 110.

The laser section 110 comprises a planar substrate 101, an active layer 102 on top of the planar substrate 101 and a first Bragg grating 115 etched through a grating layer 103 on top of the active layer 102. A top layer 105 is arranged on top of the first Bragg grating 103. In the example illustrated in FIG. 1, an optional contact layer 109 is arranged on top of the top layer 105.

In operation, the active layer 102 is configured to emit light at a predetermined central wavelength and guide said light towards the mirror section 120. The active layer 102 may comprise an ensemble of semiconductor layers, for example multi-quantum wells based on InGaAsP or InGaAlAs or other ternary or quaternary materials.

The active layer 102 and the first Bragg grating 115 may be separated by a spacer layer 104 which is standard in the prior art when fabricating DFB lasers. Such spacer layer 104 is configured to control the distance between the active layer and the first Bragg grating.

According to embodiments, the spacer layer 104 and the top layer 105 comprise the same material so that boundary between such layers is not visible in the DFB laser.

The planar substrate 101 may comprise N-doped material, such as N-doped InP. The planar substrate 101 may also comprise semi-insulating InP.

The spacer layer 104, the grating layer 103 and the top layer 105 may comprise P-doped material. For example, the spacer layer 104 and the top layer 105 may comprise P-doped InP, and the grating layer may comprise a P-doped quaternary material, such as P-doped InGaAs.

Alternatively, according to embodiments, the P-doping and the N-doping may be reversed so that the top layer 105, the spacer layer 104 and the grating layer 103 comprise N-doped material while the planar substrate 101 comprises P-doped material.

The first Bragg grating 115 is etched through the grating layer 103 and comprises alternating high-index regions and low-index regions separated by a predetermined first grating pitch. The first grating pitch depends on the wavelength of the emitted light, and may for example be comprised between about 190 nanometers and about 250 nanometers for telecom wavelengths, wherein telecom wavelengths are wavelengths comprised between about 1270 nanometers and about 1580 nanometers. In the example illustrated in FIG. 1, the high-index regions of the first Bragg grating 115 are made from parts of the grating layer 103 while the low-index regions of the first Bragg grating 115 comprise the same material as the material comprised in the top layer 105.

The laser section 110 may be configured to emit light when a voltage or current is applied between the top layer 105 and the planar substrate 101 or between materials electrically connected to the top layer 105 and the planar substrate 101.

The laser section 110 comprises a front facet 111 arranged perpendicularly to the direction of stacking of the layers 101, 102, 103, 104, 105. The front facet 111 is configured to transmit light out of the DFB laser 100.

According to embodiments, the front facet 111 comprises an anti-reflection coating configured to facilitate transmission of light at a predetermined wavelength, for example a telecom wavelength. In particular, the front facet 111 may comprise an anti-reflection coating so that reflection coefficient of light at a predetermined wavelength on the front facet 111 is inferior or equal to about 5%. According to embodiments, the anti-reflection coating comprises a couple of layers with one layer of TiO₂ and one layer of SiO₂, or a plurality of such couple of layers.

The mirror section 120 comprises the planar substrate 101, a second Bragg grating 125 arranged on top of the planar substrate 101, the top layer 105 and a rear facet 112.

The rear facet 112 may comprise an anti-reflection coating so that possible reflections of light by the rear facet 112 do not disturb reflection of light within the mirror section 120 towards the laser section 110.

The second Bragg grating 125 comprises alternating high-index regions and low-index regions separated by a predetermined second grating pitch. The second grating pitch is generally comprised between about 190 nanometers and about 250 nanometers for telecom wavelengths.

As illustrated in FIG. 1, the laser section 110 and the mirror section 120 may be covered at least partially by a contact layer 109 configured to provide ohmic contact to the top layer 105, for example in order to apply a voltage or current to the DFB laser so that it emits light. The contact layer 109 may comprise, for example, metallic materials such as Pt, Ti or Au.

The second Bragg grating 125 is arranged in a planar layer that is coplanar with the active layer 102. Light generated in the active layer 102 of the laser section 110 propagates partially towards the mirror section 120 and is reflected towards the laser section 110 upon propagation through the second Bragg grating 125.

When propagating from the laser section 110 to the mirror section 120, light acquires a predetermined phase shift that is related to the distance between the first Bragg grating 103 and the second Bragg grating 125.

According to a first embodiment, the active layer 102 extends over the mirror section 120 and the second Bragg grating 125 is produced in at least a part of the active layer 102 that is in the mirror section 120.

When the second Bragg grating 125 is produced in the active layer 102, it can be injected with a voltage or current in order to decrease absorption of light upon propagation through the second Bragg grating 125. Such injection can be facilitated, for example, by extending the contact layer 109 over the mirror section 120, as illustrated in FIG. 1.

According to one or further embodiments of the DFB laser, the active layer 102 does not extend over the mirror section 120. In such embodiments, the second Bragg grating 125 is produced in an auxiliary waveguide layer comprising a transparent material, i.e., a material with an energy bandgap larger than the energy of a photon emitted by the laser section. Such transparent material can comprise, for example, a stack of multiple quantum wells separated by barriers or a bulk material where the energy bandgap of the quantum wells or bulk material is larger than the energy of a photon emitted by the laser section 110.

When the second Bragg grating 125 is produced in an auxiliary waveguide layer comprising a transparent material, it does not need electrical control and naturally has a low absorption coefficient, for example an absorption coefficient inferior to about 15 cm⁻¹.

Applicants have shown that in embodiments as those described in reference to FIG. 1, the reflectivity of the mirror section 120 may be superior to about 200 cm⁻¹ due to the fact that when light propagates in the mirror section 120, guided light modes have an improved overlap with the second Bragg grating 125 compared to designs of the prior art.

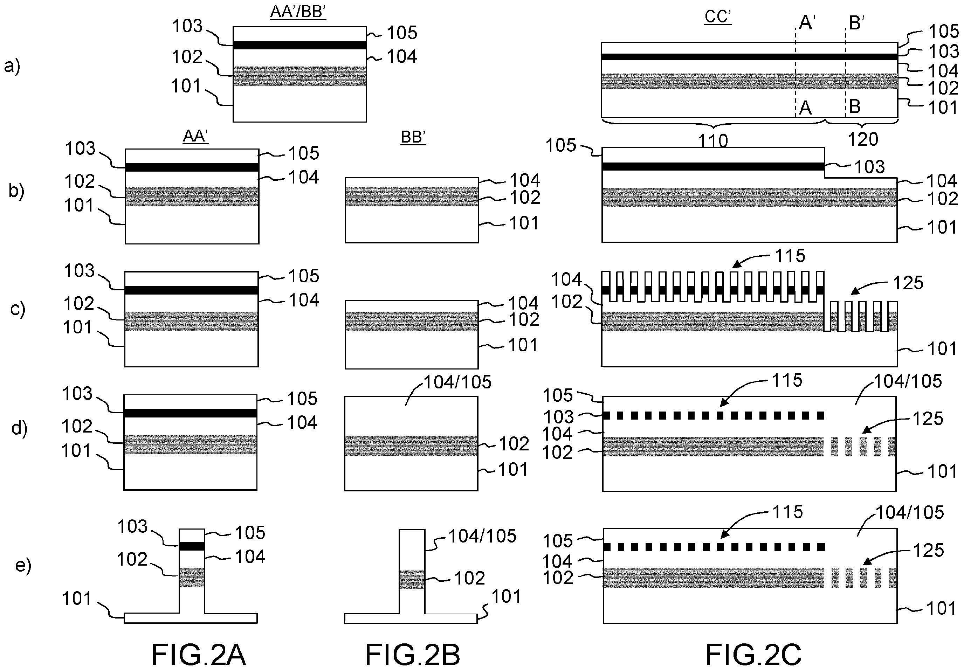

FIGS. 2A-2C represent steps of a method for fabricating a DFB laser according to a first embodiment. In particular, FIGS. 2A-2C illustrate different steps (a) to (e) of a fabrication method of a DFB laser under several sectional views (A-A', B-B', CC'), respectively. Sectional view A-A' illustrates the stacking of layers in the laser section 110. Sectional view B-B' illustrates the stacking of layers in the mirror section 120. Sectional view C-C' illustrates the stacking of layers within the DFB laser along the direction of light propagation, i.e. throughout the laser section 110 and the mirror section 120.

In step (a), an ensemble of layers 101, 102, 103, 104, 105 is provided. Such ensemble comprises an N-doped planar substrate 101, an active layer 102 comprising active material configured to emit light; and a P-doped spacer layer 104, a P-doped grating layer 103, and a P-doped top layer 105.

In the start of the fabrication process, in step (a), the top layer 105 has a very small thickness, for example a thickness of about 20 nanometers, which is comparably smaller than the thickness of the top layer 105 in the DFB laser illustrated in FIG. 1, wherein epitaxy regrowth has been performed to increase the thickness of the top layer 105 up to about 2 to 3 micrometers.

According to embodiments, the active layer 102 may comprise, for example, multi-quantum wells configured to emit light.

According to embodiments, the grating layer 103 may comprise InGaAsP material. The grating layer 103 may have a thickness comprised between about 20 nanometers and about 80 nanometers.

According to embodiments, the spacer layer 104 may have a thickness comprised between about 70 nanometers and 120 nanometers.

In step (b), a mask (not represented in FIGS. 2A-2C) is deposited on a first section 110 of the ensemble of layers 101, 102, 103, 104, 105, the rest of the ensemble of layers defining a second section 120. Such mask is used to etch totally the grating layer 103 in said second section 120 in order to uncover the spacer layer 104. The first section 110 is intended to form a laser section wherein light is generated and the second section 120 is intended to form a mirror section configured to reflect the light generated by the first section 110 towards said first section 110. Therefore, in the present description, the first section 110 is referred to as the laser section 110 and the second section 120 is referred to as the mirror section 120.

Further, as illustrated in FIG. 2C, in step (b), the etch may be further configured to remove a predetermined thickness of the spacer layer 104 in order to reach the proximity of the upper surface of the active layer 102 and increase the etching depth into the active layer 102. Such increased etching depth improves the coupling strength in the mirror section of a DFB laser obtained with the method according to the present description. In particular, according to embodiments not illustrated in the present description, the etch is configured to remove the entire thickness of the spacer layer 104 in the mirror section in order to maximize the etching depth.

In step (c), a grating mask (not represented in FIGS. 2A-2C) is deposited on both the first section 110 and the second section 120. A first and a second Bragg gratings (115, 125) are then simultaneously defined on such grating mask by structuration of the grating mask, for example by e-beam, holography or other techniques known from the skilled man.

Further, such first and second Bragg gratings (115, 125) are then produced by etching parts of the first section and parts of the second section using said grating mask, respectively. The grating mask is configured to produce, after the etching, a first Bragg grating 115 and a second Bragg grating 125 separated by a predetermined distance. For example, a distance comprised between about 0 nanometers and about 10 micrometers.

According to embodiments, the etching of the first Bragg grating 115 and the etching of second Bragg grating 125 may be performed in a single step. According to other embodiments, the etching of the first Bragg grating 115 and the etching of the second Bragg grating 125 may be performed in two different steps.

The first Bragg grating 115 is produced in the first section 110 by etching through the top layer 105 and the grating layer 103. Further, as illustrated in FIGS. 2C, a predetermined thickness of the spacer layer 104 can also be etched in order to ensure that all the thickness of the grating layer 103 has been etched in the laser section 110 and to reduce the sensitivity of the coupling strength in the laser section to the etching depth in the laser section.

The second Bragg grating 125 is produced in the mirror section 120 by etching through the spacer layer 104 remaining after the etch of step (b), and through the active layer 102. Further, unlike the example illustrated in FIG. 2C, a part of the planar substrate 101 can also be etched to ensure that all the thickness of the active layer 102 has been etched in the mirror section 120 in order to reach the highest possible grating strength and to reduce the sensitivity of the coupling strength of the mirror section 120 to the etching depth in the active layer 102.

In step (d), trenches in the mirror section 120 caused by the etch are filled up using an epitaxy regrowth with P-doped material, for example the same material as the material comprised in the top layer 105. Further, such regrowth aims at planarizing the upper surface of laser section 110 and the mirror section 120. This regrowth may comprise, for example, adding 200 nanometers to 500 nanometers of P-doped material, such as P-doped InP.

In step (e), a final etch is performed to produce the optical waveguide. In the example illustrated in FIGS. 2A-2C, the waveguide is a buried waveguide. The waveguide could be further buried into P-doped or semi-insulating material such as InP.

Alternatively, step (d) could comprise a thicker regrowth of P-doped material, for example up to about 2 micrometers or up to about 3 micrometers.

For example, in step (e), the final etch could be performed only through the thick P-doped material (i.e., layers 105, 103, 104) in order to produce a shallow ridge waveguide.

As another example, in step (e), the final etch could be performed through the P-doped material (i.e., layers 105, 103, 104) and through the active layer 102 in order to produce a deep ridge waveguide.

After step (e), additional steps known from to the skilled person may be performed in order to obtain a finalized DFB laser.

In the method according to the present description, the second Bragg grating 125 is etched mainly through the active layer 102 so that the coupling strength of the mirror section 120 is superior to the coupling strength of mirror sections in DFBs of the prior art. In particular, a DFB laser obtained using the method according to the present description comprises a mirror section 120 wherein the coupling strength is superior to 200 cm⁻¹.

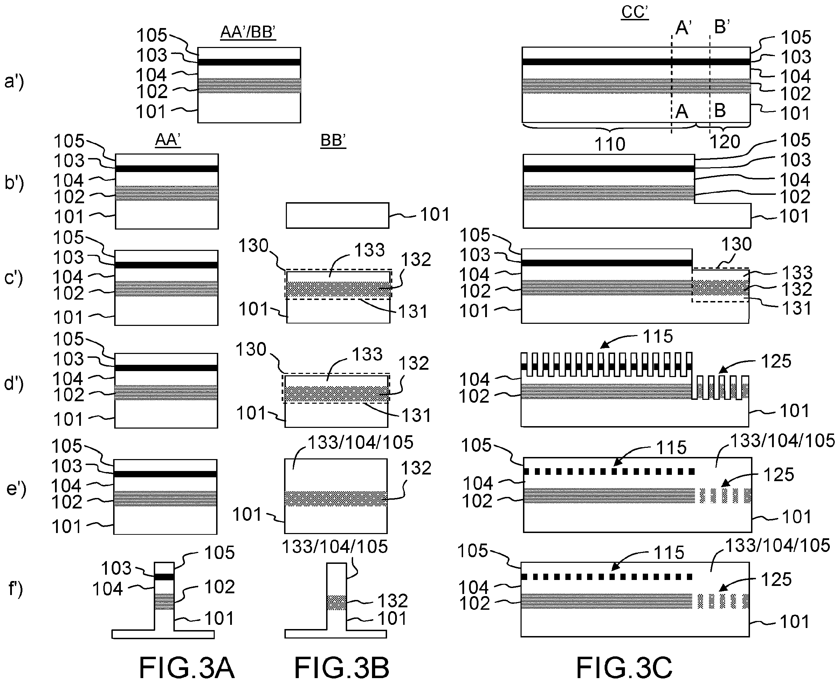

FIGS. 3A-3C represent steps of a method for fabricating a DFB laser comprising a second Bragg grating (125) that is produced in a transparent waveguide layer (132) coupled to the active layer (102). FIGS. 3A-3C illustrate different steps (a') to (f') of the fabrication method of a DFB laser under several sectional views (A-A', B-B', CC'), respectively. Sectional view A-A' illustrates the stacking of layers in the laser section 110. Sectional view B-B' illustrates the stacking of layers in the mirror section 120. Sectional view C-C' illustrates the stacking of layers within the DFB laser along the direction of light propagation, i.e., throughout the laser section 110 and the mirror section 120.

As illustrated in FIGS. 3A-3C, step (a') is identical to the step (a) as already presented. In particular, an ensemble comprising layers 101, 102, 103, 104, 105 is provided. Such ensemble comprises an N-doped planar substrate 101, an active layer 102 comprising active material configured to emit light, a P-doped spacer layer 104, a P-doped grating layer 103, and a P-doped top layer 105.

In step (b'), a mask is deposited on a first section 110 of the ensemble of layers 101, 102, 103, 104, 105, the rest of the ensemble of layers defining a second section 120. Similarly to the first embodiment, in the second embodiment the first section 110 is intended to form a laser section wherein the light is generated and the second section 120 is intended to form a mirror section configured to reflect the light generated by the first section 110 towards said first section 110.

After the mask is deposited, the top layer 105, the grating layer 103, the spacer layer 104 and the active layer 102 are etched from the second section 120.

Further, in step (b'), the etch may be configured to further remove a predetermined thickness of the planar substrate 101 in order to ensure that all the thickness of the active layer 102 is etched in the mirror section 120. This also makes it possible to perform, in a subsequent step, a regrowth starting from the planar substrate 101 which acts as a buffer layer facilitating regrowth compared to a regrowth starting from a remaining thickness of active layer 102.

In step (c'), an ensemble 130 of semiconductor layers comprising an auxiliary waveguide layer 132 is integrated to the mirror section 120 so that it is coupled to the laser section 110. In particular, the auxiliary waveguide layer 132 of said ensemble 130 is coupled to the active layer 102 of the laser section 110.

Although, in FIGS. 3A-3C, step (c') specifically illustrates an integration based on butt-coupling technology, other techniques could alternatively be used, such as evanescent coupling, selective area growth or intermixing. The skilled person will know how to adapt the steps of the method to the integration technique that is used.

Once coupled to the laser section 110, the auxiliary waveguide layer 132 is configured to receive and guide light emitted by said laser section 110.

As illustrated in FIGS. 3A-3C, the ensemble 130 of semiconductor layers may comprise an auxiliary substrate layer 131 and an auxiliary top layer 133. The auxiliary substrate layer 131 may comprise the same material as the planar substrate 101. The auxiliary top layer 133 may comprise the same material as the spacer layer 104.

Advantageously, the ensemble 130 of semiconductor layers has a structure that is used in elements of photonic integrated circuits, for example a structure used in a modulator, a coupler, or a multiplexer.

According to embodiments not illustrated in FIGS. 3A-3C, in step (c'), the upper surface of the ensemble 130 may be much higher than the top surface of layer 102 so that additional etching steps may be implemented in order to remove at least a part of the auxiliary top layer 133 and reach proximity of auxiliary waveguide layer 132. For example, an etching step similar to step (b) in FIG.2. may be implemented.

Steps (d'), (e'), (f') of the example illustrated in FIGS. 3A-3C are similar to the steps (c), (d), (e) of the example illustrated in FIGS. 2A-2C, a difference being that, in the example illustrated in FIGS. 3A-3C, the second Bragg grating 125 is produced by etching through the auxiliary waveguide layer 132 instead of etching through the active layer 102.

In the example illustrated in FIGS. 3A-3C, the integration of an auxiliary waveguide layer 132 in the mirror section 120 may advantageously be done at no cost if the DFB laser belongs to a photonic integrated circuit that comprises sections such as couplers, multiplexers or modulators. Interestingly, in such cases, such sections are also produced using integration techniques so that steps (b') and (c') are already part of the fabrication process of the photonic integrated circuit. Therefore, the method according to the present description is particularly simple to implement.

While the invention has been described with respect to a limited number of embodiments, those skilled in the art, having benefit of this disclosure, will appreciate that other embodiments can be devised which do not depart from the invention as disclosed herein. Accordingly, the scope of the invention should be limited only by the attached independent claims.

## Claims

1. A method for fabricating a DFB laser, comprising:
- providing a planar substrate (101), an active layer (102) substantially parallel to the planar substrate (101) but not coplanar with said planar substrate, and a grating layer (103) arranged in a planar layer substantially parallel to said active layer (102) but not coplanar with said active layer (102) and arranged on a side of the active layer (102) opposite to the planar substrate (101);
- covering with a mask a first section of an ensemble made of said planar substrate (101), said active layer (102) and said grating layer (103), wherein said first section (110) is intended to produce a laser section (110);
- removing at least the grating layer (103) in a second section (120) of said ensemble made of said planar substrate (101), said active layer (102) and said grating layer (103), wherein said second section is intended to produce a mirror section (120);
- providing, in a single step, a grating mask covering at least partially the first section (110) and at least partially the second section (120); such grating mask being configured to define a first Bragg grating (115) in the first section (110) and a second Bragg grating (125) in the second section (120);
- producing, using said grating mask, the first Bragg grating (115) in the grating layer (103) of the first section (110) and the second Bragg grating (125) in a planar layer of the second section (120) that is coplanar with the active layer (102).

2. The method according to claim 1, wherein the first Bragg grating (115) and the second Bragg grating (125) are produced using said grating mask, in a single step.

3. The method according to any of claims 1 to 2, wherein:
- the second Bragg grating (125) is produced in at least a part of said active layer (102) that extends in the second section (120).

4. The method according to claim 3, wherein said part of the active layer has a thickness between about 50 nanometers and about 200 nanometers, preferably between about 50 nanometers and about 120 nanometers.

5. The method according to any of claims 1 to 2, wherein:
- the second Bragg grating (125) is produced in at least a part of an auxiliary waveguide (132) that is coupled to the active layer (102) of the first section (120).

6. The method according to claim 5, wherein the active layer (102) and said auxiliary waveguide (132) are coupled through butt-coupling, evanescent coupling, selective area growth or intermixing.

7. The method according to any of claims 5 to 6, wherein said auxiliary waveguide is a passive waveguide.

8. The method according to any of the preceding claims, wherein a spacing between the first Bragg grating (115) of the laser section (110) and the second Bragg grating (125) of the mirror section (120) is introduced so that light propagating from the first Bragg grating (115) to the second Bragg grating (125) acquires a phase shift equal to about π/2.

9. The method according to any of the preceding claims, wherein the mirror section (120) has a length along the direction of light propagation that is inferior to about 200 micrometers.

10. The method according to any of the preceding claims, wherein the DFB laser is configured to be a directly modulated laser.

## Patentansprüche

1. Ein Verfahren zur Herstellung eines DFB-Lasers, die folgenden Schritte aufweisend:
- Bereitstellen eines ebenen Substrats (101), einer aktiven Schicht (102), die im Wesentlichen parallel zu dem ebenen Substrat (101), aber nicht koplanar mit dem ebenen Substrat ist, und einer Gitterschicht (103), die in einer ebenen Schicht im Wesentlichen parallel zu der aktiven Schicht (102), aber nicht koplanar mit der aktiven Schicht (102) und auf einer Seite der aktiven Schicht (102) gegenüber dem ebenen Substrat (101) angeordnet ist;
- Bedecken eines ersten Abschnitts eines Ensembles aus dem ebenen Substrat (101), der aktiven Schicht (102) und der Gitterschicht (103) mit einer Maske, wobei der erste Abschnitt (110) dazu bestimmt ist, einen Laserabschnitt (110) zu erzeugen;
- Entfernen zumindest der Gitterschicht (103) in einem zweiten Abschnitt (120) des Ensembles aus dem ebenen Substrat (101), der aktiven Schicht (102) und der Gitterschicht (103), wobei der zweite Abschnitt dazu bestimmt ist, einen Spiegelabschnitt (120) zu erzeugen;
- Bereitstellen, in einem einzigen Schritt, einer Gittermaske, die zumindest teilweise den ersten Abschnitt (110) und zumindest teilweise den zweiten Abschnitt (120) abdeckt; wobei diese Gittermaske konfiguriert ist, um ein erstes Bragg-Gitter (115) in dem ersten Abschnitt (110) und ein zweites Bragg-Gitter (125) in dem zweiten Abschnitt (120) zu definieren;
- Erzeugen, unter Verwendung der Gittermaske, des ersten Bragg-Gitters (115) in der Gitterschicht (103) des ersten Abschnitts (110) und des zweiten Bragg-Gitters (125) in einer ebenen Schicht des zweiten Abschnitts (120), die koplanar mit der aktiven Schicht (102) ist.

2. Das Verfahren nach Anspruch 1, wobei das erste Bragg-Gitter (115) und das zweite Bragg-Gitter (125) unter Verwendung der Gittermaske in einem einzigen Schritt hergestellt werden.

3. Das Verfahren nach einem der Ansprüche 1 bis 2, wobei:
- das zweite Bragg-Gitter (125) in mindestens einem Teil der aktiven Schicht (102) erzeugt wird, der sich in den zweiten Abschnitt (120) erstreckt.

4. Das Verfahren nach Anspruch 3, wobei der besagte Teil der aktiven Schicht eine Dicke zwischen etwa 50 Nanometern und etwa 200 Nanometern, vorzugsweise zwischen etwa 50 Nanometern und etwa 120 Nanometern aufweist.

5. Das Verfahren nach einem der Ansprüche 1 bis 2, wobei:
- das zweite Bragg-Gitter (125) in zumindest einem Teil eines Hilfswellenleiters (132) erzeugt wird, der mit der aktiven Schicht (102) des ersten Abschnitts (120) gekoppelt ist.

6. Das Verfahren nach Anspruch 5, wobei die aktive Schicht (102) und der Hilfswellenleiter (132) durch Stoßverbindung, evaneszente Kopplung, selektives Flächenwachstum oder Vermischung gekoppelt sind.

7. Das Verfahren nach einem der Ansprüche 5 bis 6, wobei der Hilfswellenleiter ein passiver Wellenleiter ist.

8. Das Verfahren nach einem der vorhergehenden Ansprüche, wobei ein Abstand zwischen dem ersten Bragg-Gitter (115) des Laserabschnitts (110) und dem zweiten Bragg-Gitter (125) des Spiegelabschnitts (120) so eingeführt wird, dass Licht, das sich von dem ersten Bragg-Gitter (115) zu dem zweiten Bragg-Gitter (125) ausbreitet, eine Phasenverschiebung von etwa π/2 erfährt.

9. Das Verfahren nach einem der vorhergehenden Ansprüche, wobei der Spiegelabschnitt (120) eine Länge entlang der Lichtausbreitungsrichtung hat, die kleiner als etwa 200 Mikrometer ist.

10. Das Verfahren nach einem der vorangehenden Ansprüche, wobei der DFB-Laser als direkt modulierter Laser konfiguriert ist.

## Revendications

1. Procédé de fabrication d'un laser DFB, comprenant :
- la fourniture d'un substrat plan (101), d'une couche active (102) sensiblement parallèle au substrat plan (101) mais non coplanaire avec ledit substrat plan, et d'une couche de réseau (103) disposée dans une couche plane sensiblement parallèle à ladite couche active (102) mais non coplanaire avec ladite couche active (102) et disposée d'un côté de la couche active (102) opposé au substrat plan (101) ;
- le recouvrement par un masque d'une première section d'un ensemble constitué dudit substrat plan (101), de ladite couche active (102) et de ladite couche de réseau (103), ladite première section (110) étant destinée à produire une section laser (110) ;
- l'enlèvement d'au moins la couche de réseau (103) dans une seconde section (120) dudit ensemble constitué dudit substrat plan (101), de ladite couche active (102) et de ladite couche de réseau (103), ladite seconde section étant destinée à produire une section miroir (120) ;
- la fourniture, en une seule étape, d'un masque de réseau couvrant au moins partiellement la première section (110) et au moins partiellement la seconde section (120), ledit masque de réseau étant configuré pour définir un premier réseau de Bragg (115) dans la première section (110) et un second réseau de Bragg (125) dans la seconde section (120) ;
- la production, à l'aide dudit masque de réseau, du premier réseau de Bragg (115) dans la couche de réseau (103) de la première section (110) et le second réseau de Bragg (125) dans une couche plane de la seconde section (120) qui est coplanaire avec la couche active (102).

2. Procédé selon la revendication 1, dans lequel le premier réseau de Bragg (115) et le second réseau de Bragg (125) sont produits à l'aide dudit masque de réseau, en une seule étape.

3. Procédé selon l'une quelconque des revendications 1 à 2, dans lequel :
- le second réseau de Bragg (125) est produit dans au moins une partie de ladite couche active (102) qui s'étend dans la seconde section (120).

4. Procédé selon la revendication 3, dans lequel ladite partie de la couche active a une épaisseur comprise entre environ 50 nanomètres et environ 200 nanomètres, de préférence entre environ 50 nanomètres et environ 120 nanomètres.

5. Procédé selon l'une quelconque des revendications 1 à 2, dans lequel :
- le second réseau de Bragg (125) est produit dans au moins une partie d'un guide d'ondes auxiliaire (132) qui est couplé à la couche active (102) de la première section (120).

6. Procédé selon la revendication 5, dans lequel la couche active (102) et ledit guide d'ondes auxiliaire (132) sont couplés par couplage bout à bout, couplage évanescent, croissance de zone sélective ou mélange.

7. Procédé selon l'une quelconque des revendications 5 à 6, dans lequel ledit guide d'ondes auxiliaire est un guide d'ondes passif.

8. Procédé selon l'une quelconque des revendications précédentes, dans lequel un espacement entre le premier réseau de Bragg (115) de la section laser (110) et le second réseau de Bragg (125) de la section miroir (120) est introduit de sorte que la lumière se propageant du premier réseau de Bragg (115) au second réseau de Bragg (125) acquiert un déphasage égal à environ π/2.

9. Procédé selon l'une quelconque des revendications précédentes, dans lequel la section miroir (120) a une longueur le long de la direction de propagation de la lumière qui est inférieure à environ 200 micromètres.

10. Procédé selon l'une quelconque des revendications précédentes, dans lequel le laser DFB est configuré pour être un laser à modulation directe.
